# EUROPEAN PATENT SPECIFICATION

(11) **EP 3 175 683 B1**
(45) Date of publication and mention of the grant of the patent: **26.05.2021**
(21) Application number: 15711835.7
(22) Date of filing: 11.02.2015
(51) Int. Cl.: H05K 1/18, H05K 1/02

(54) **PRINTED CIRCUIT FOR BACKLIGHTING EQUIPMENT**
LEITERPLATTE FÜR RÜCKBELEUCHTUNGSAUSRÜSTUNG
CIRCUIT IMPRIMÉ POUR ÉQUIPEMENT À RÉTROÉCLAIRAGE

(30) Priority: 01.08.2014 IT PD20140210
(43) Date of publication of application: 07.06.2017
(73) Proprietor: Iotty Srl, 33080 Porcia (PN) (IT)
(72) Inventor: BACCHIN, Alberto, I-34122 Trieste (TS) (IT)
(74) Representative: Vinci, Marcello
(86) International application number: PCT/IB2015/051016
(87) International publication number: WO 2016/016735

(56) References cited:
- DE-A1-102008 047 406
- JP-A- 2003 152 296
- US-A1- 2009 126 980

## Description

This patent relates to electrical and electronic devices and in particular concerns a new printed circuit board according to claim 1, with an integrated system for backlighting equipment in general, with a resulting backlit electronic device and backlit capacitive button.

The prior art includes electronic devices equipped with a backlight, suitable to signal, indicate, or increase the visibility of parts or buttons on the equipment itself.

Printed circuits on which light fixtures are mounted, such as LEDs, suitable to be positioned in such a way that these lighting bodies are in position behind the respective parts, icons, or buttons, to be backlit are known in the prior art.

For example there are backlit buttons, whether of the mechanical or capacitive or another type.

For instance, the backlit buttons of the capacitive type, comprise a capacitive sensor, positioned behind a layer of insulating material suited to be touched by the user to actuate the button.

This capacitive sensor is connected to an electronic card behind it, in turn comprising a printed circuit on which a lighting body is mounted, such as an LED, in a position corresponding to that of the sensor.

The printed circuit boards in the prior art comprise a solid substrate, generally flat, flexible or rigid, and where on one or both faces of the substrate a layer of conductive material is applied, typically copper, from which the excess material to achieve the network of connections is then eliminated. Mounted on this printed circuit are also electrical and electronic components necessary for the operation of the equipment.

Through holes are generally made on these printed circuit boards to insert these mounted components or to make the electrical connection between the copper layers of the two opposite sides of the substrate.

Lighting fixtures are also mounted and connected on these printed circuit boards, for example LEDs, which are connected on one side of the printed circuit or inserted in the through holes, to emit light from the opposite side.

In a frontal position to these LEDs, and in any case at a certain distance from the printed circuit due mainly to the footprint of the LED, a second support is mounted on which the capacitive buttons are mounted or on which there are icons or the like to be backlit.

Currently, therefore, the overall dimensions of the printed circuit board with LED lighting bodies is determined by the thickness of the circuit itself and the interspace created between the printed circuit board and the support in front of it.

This type of circuit board with LEDs for backlighting are therefore difficult to apply in particular situations where it is essential to limit the overall thickness, and also establishes minimum dimensions constraints in the construction of the equipment in which it is applied.

"Reverse LEDs" are known in the prior art, mounted on one side of a printed circuit so as to illuminate the opposite side. In this configuration, the LEDs are mounted and structured so as to emit light by means of through holes drilled on the printed circuit board.

To increase the diffusion of the light emitted through the hole, a certain distance must still be maintained between the circuit and the support with the capacitive area, otherwise the light beam may be too narrow and thus hardly visible and not very effective for the backlighting.

JP 2003 152296 A relates to a printed circuit provided with a through hole on which a LED is mounted and wherein said LED occupies the entire height of the hole.

US2009126980 A1 discloses that in a printed wiring board, contacts are formed only on one side surface of a printed board, and electronic components, including an LED, are arranged only on the other side surface of the printed board.

DE 10 2008 047406 A1 describes a system formed by a first substrate comprising two though holes on which lighting bodies are mounted, a second substrate having a though opening positioned correspondingly to said lighting bodies and a further layer having a through opening in which an optically neutral insert is located.

To overcome the above drawbacks a new type of printed circuit board according to claim 1 has been designed and constructed with an integrated backlighting system, with a resulting backlit electronic device and backlit capacitive button.

The main object of the present invention is to minimize the thickness of the printed circuit board with an integrated backlighting system.

Another object of the present invention is to integrate the technical function corresponding to the diffusion of the light emitted by one or more lighting bodies integrated in the printed circuit itself.

Yet another object of the present invention is to minimize the thickness of the backlit equipment.

Still another object of the present invention is to achieve a backlit capacitive button with reduced thickness.

The present invention is particularly applicable for backlighting in electrical or electronic equipment, for backlighting icons, mechanical or capacitive buttons, and for light signals in general.

The present invention is also applicable to all electrical or electronic equipment related to home automation, automotive, medical, industrial, lighting technology, household appliances, catering, vending, and multimedia.

These and other objectives, direct and complementary, are achieved by the printed circuit board according to claim 1, with integrated backlighting system, with a resulting backlit electronic device and backlit capacitive button.

The printed circuit according to the invention is made of one flat, substrate in a solid material, rigid or flexible, having a given thickness, with at least one first side suited to the application of the network connection and assembly of components including at least one lighting body, such as a LED, and one or more through holes, where at least one of these holes is suited to the housing of the at least one lighting body or LED, mounted on the first side and facing the opposite side or emissive side, and where the hole is countersunk toward the emissive side or otherwise shaped in such a way that the opening of the hole on the emissive side is larger than the size of the LED, that is, larger than the size of the section of the hole in which the LED is housed.

In this way, at least part of this hole acts as a diffuser of the light emitted by the corresponding LED, and where at least the inner wall of the hole is completely or partially covered by or made of reflective material.

For example, this internal wall of the holes, and preferably also the emissive side of the support, are entirely painted white or another highly reflective colour or galvanically plated.

According to the invention, this hole is composed of a first section of the hole formed on the first side of the LED housing, with a shape and dimensions substantially corresponding to the LED to be installed, and a second section of the hole made on the emissive side and communicating with the first section, where the second section of the hole is larger, and for example has a circular shape, but not necessarily, substantially centred on the first section of the hole.

This second section may be countersunk, for example conical with an increasing diameter toward the emissive side, or substantially cylindrical or prismatic.

This hole is made mechanically and internally painted, or plated by means of an electrolytic process.

Alternatively, the substrate may be made of a material already equipped with reflective properties.

Therefore, the holes are made in the thickness of the printed circuit board and also serve as diffusers of the light emitted by the one or more LEDs. It is not necessary to leave any interspace between the circuit and any support in front of it, with or without capacitive buttons.

Within the hole, in the thickness of the substrate, an element to diffuse the light may be inserted, for example a lens or the like, placed in front of the LED.

The printed circuit according to the invention is particularly suited to be applied in the construction of backlit electronic or electrical devices, such as backlit capacitive buttons with a reduced thickness.

The new electric or electronic device includes at least one support with at least one part to be backlit, for example, an icon or a button, and at least one of these printed circuit boards with an integrated backlighting system where the support with the part to be backlit can be positioned close to or even flush with, directly or indirectly, the emissive side of the printed circuit. For example the new backlit capacitive button comprises at least one support with a capacitive sensor, where the support is substantially superimposed on and directly or indirectly adheres to the emissive side of the printed circuit, without interspaces between them.

The characteristics of the present invention will be better clarified by the following description with reference to the drawings, attached by way of non-limiting example.
Figure 1 shows a section of part of the new printed circuit board (4), where there is a visible hole (2) shaped and countersunk for the optimal diffusion of the light emitted by a lighting body (3), for example an LED, assembled on the printed circuit (4).
Figure 1a shows a section of part of the new printed circuit board (4) in another embodiment, with a light diffusion element (5) integrated.
Figure 1b shows a section of part of the new printed circuit board (4) in a further embodiment, with the hole (2) comprising a first substantially cylindrical or prismatic section (23) housing a lighting fixture (3) and a second substantially frustoconical section (24), that is countersunk for the optimal diffusion of the light emitted by the lighting body (3).

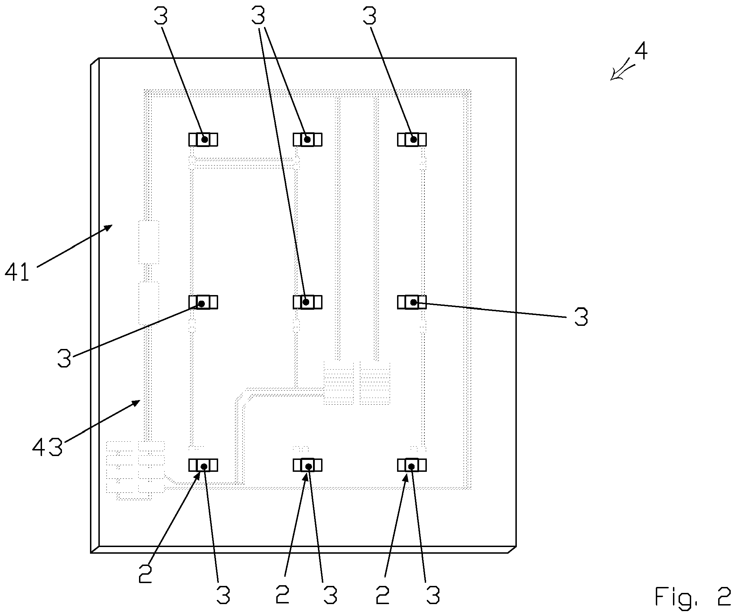

Figure 2 shows a view of the first side (41) of the printed circuit (4) comprising a substrate (1) with holes (2) shaped and countersunk and the network of connections (43), indicated with lines.

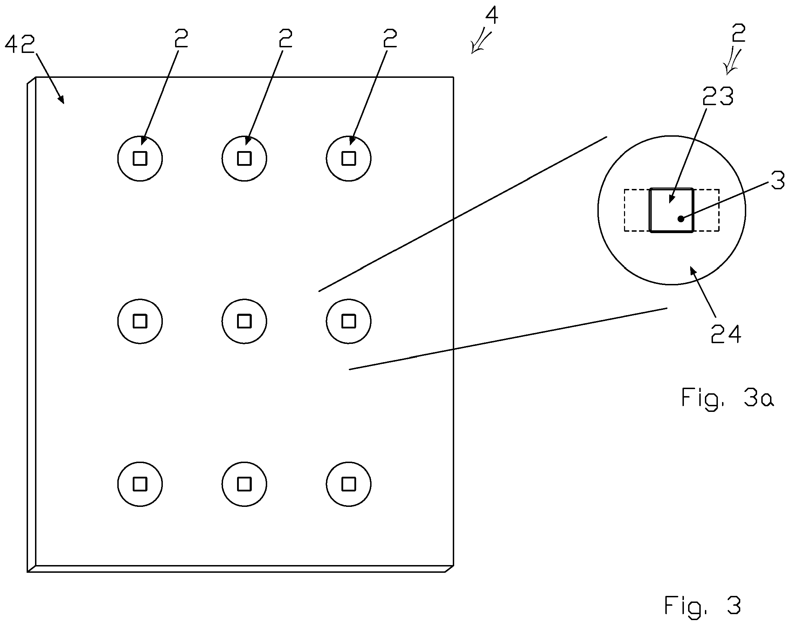

Figure 3 shows a view of the opposite side (42) of the printed circuit (4), where the holes (2) are visible.
Figure 3a shows in detail a view of only the hole (2) with the lighting body (3) installed.
Figure 4 shows a section of part of a backlit capacitive button or plate (6) in general, comprising the new printed circuit board (4).

This is a printed circuit board (4), particularly suitable for the assembly of one or more lighting fixtures (3), such as LEDs, with an integrated system for backlighting.

The printed circuit (4) is made of one flat substrate (1), in a rigid or flexible solid material, having a certain thickness.

This substrate (1) comprises a first side (11) suited to the application of network connections (43) and assembly of the components including at least one lighting body (3), for example an LED.

This lighting body (3) is preferably of the "reverse LED" type, that is suited to be mounted on the first side (11) of the substrate (1), inserted in a through hole (2) created on the substrate (1) and facing the opposite side or emissive side (12) of the substrate (1).

Thus one or more holes (2) are made on this substrate (1) where at least one of the holes (2) is suited to the housing of the lighting body (3) assembled on the first side (11), inserted in the opening (21) of the hole (2), and facing the opposite emissive side (12).

This hole (2) is specially shaped and in particular is countersunk, with an increasing section toward the emissive side (12), or otherwise shaped in such a way that the opening (22) of the hole (2) on the emissive side (12) is larger than the size of the lighting body (3), that is the size of the section (23) of the hole (2) in which the lighting body (3) is housed.

In the embodiment represented in the figures, each of the holes (2) to house a lighting body (3) comprises the first section (23), created on the first side (11), having a shape and dimensions substantially corresponding to those of the lighting body (3) housed or in any case such as to allow its housing. This first section (23) has for example a substantially rectangular or square shape and height sufficient to substantially completely house the lighting body (3). This hole (2) also comprises a second section (24), created on the emissive side (12) and communicating with the first section (23).

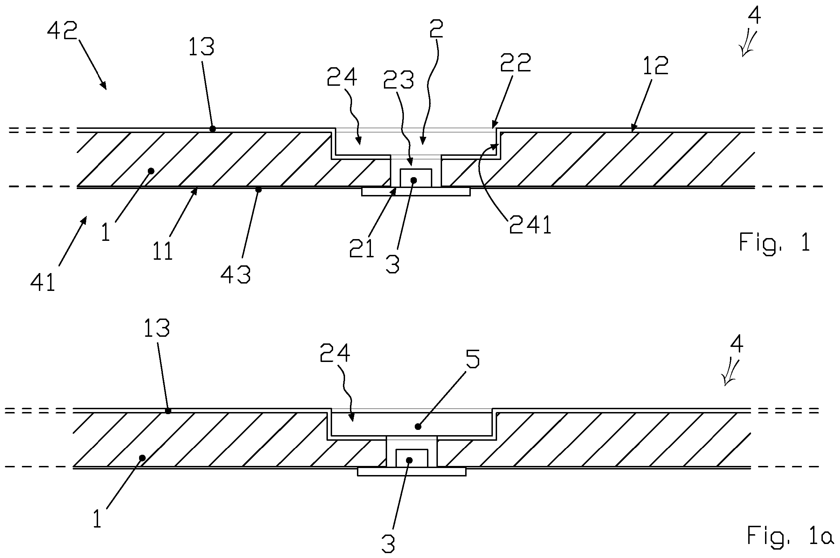

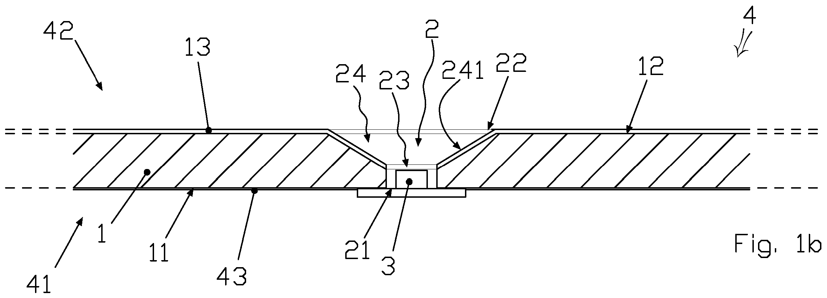

In the embodiment in Figures 1 and 1a, the second section (24) has, in plan view, larger dimensions than the first section (23), and has for example a shape which is circular, polygonal or another shape substantially centred on the first section (23).

In the embodiment in Figure 1b, the second section (24) has a truncated cone shape that is substantially centred or coaxial with the first section (23), the second truncated cone section (24) being countersunk towards the emissive side (12).

In this way, at least part of the hole (2), that second section (24), serves as a diffuser of the light emitted from the lighting body (3) housed in the hole (2) itself.

At least the inner wall (241) of the second section (24) of the hole (2) is covered with or made of reflective material, such as white paint or metal plating.

In the preferred embodiment, the inside walls of the holes (2) and the emissive side (12) of the substrate (1) are fully or partly painted or coated or otherwise made of reflective material (13), for example painted white or metal plated.

In the embodiment in Figure 1a, at least one light diffusing element (5) is represented by a dashed line, housed inside the hole (2), in particular completely recessed in the thickness of the substrate (1) in a position in front of the lighting body (3) having the purpose of increasing the diffusion of the light emitted from the lighting body (3) itself.

This diffusing element (5) is for example housed in the second section (24) of the relative hole (2).

This light diffusing element (5) may for example be made of resin or another material able to transmit light.

Using the new printed circuit board (4) it is possible to attain a backlit device, such as a backlit capacitive button (6) with reduced thickness.

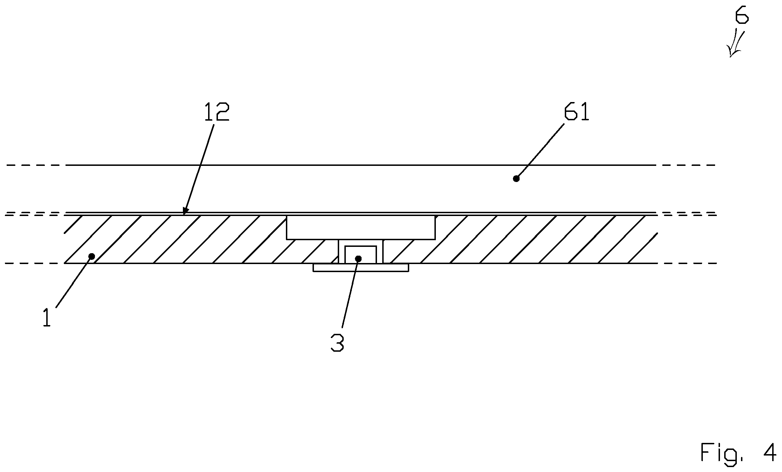

As shown in Figure 4, the backlit capacitive button or plate (6) comprises at least one support (61), with or without a capacitive sensor, and at least one printed circuit board (4), positioned so that at least one illuminating body (3) is in position behind at least part of the support (61) of that capacitive button or plate for backlighting (6).

The support (61), with or without a capacitive sensor, is superimposed on and directly or indirectly adheres to the emissive side (12) of the printed circuit board (4), with no need to leave an interspace.

Therefore, with reference to the preceding description and the attached drawings the following claims are made.

## Claims

1. Printed circuit (4) made of one flat substrate (1) in a rigid or flexible solid material, substrate (1) having at least one first side (11) suitable for the application of the connection network (43) and for the assembly of components, one or more through holes (2) made in said substrate (1), at least one of said holes (2) comprising a first section (23) suited to house at least part of at least one lighting body (3) mounted on said first side (11) and facing towards the opposite side or emissive side (12) of said substrate (1),
and wherein at least one lighting body (3) of the LED type is housed in said section (23) of at least one of said holes (2),
and wherein said at least one hole (2) housing said lighting body (3) is countersunk towards said emissive side (12) or in any case shaped in such a way that the opening (22) of said hole (2) in said emissive side (12) is larger than said first section (23) housing said lighting body (3), and wherein each one of said holes (2) housing a lighting body (3) comprises:
• said first section (23) obtained on said first side (11) and having shape and height, said first section substantially housing the entirety of the lighting body (3);
• at least one second section (24) obtained on said emissive side (12) and communicating with said first section (23), wherein said second section (24) in plan view is larger than said first section (23),
and wherein said second section (24) serves as a diffuser for the light emitted by the lighting body (3) housed in the hole (2) itself.

2. Printed circuit (4) according to claim 1, **characterized in that** said second section (24) has a circular, polygonal or any shape, substantially centred on said first section (23).

3. Printed circuit (4) according to the preceding claims, **characterized in that** at least the inner wall (241) of said second section (24) of said hole (2) is painted or made of or in any case covered with a reflecting material and/or a metal plating.

4. Printed circuit (4) according to the preceding claims, **characterized in that** at least the inner walls of said holes (2) and said emissive side (12) of said substrate (1) are completely or partially painted or made of or in any case covered with a reflecting material (13) and/or a metal plating layer.

5. Printed circuit (4) according to the preceding claims, **characterized in that** it also comprises at least one light diffusing element (5), completely or partially housed in said hole (2), in a position before said lighting body (3) and having the purpose of increasing diffusion of the light emitted by the lighting body (3) itself.

6. Electric or electronic backlit device, comprising at least one support with at least one portion to be backlit and at least one printed circuit (4) with at least one lighting body (3) positioned in such a way as to backlight said at least one portion to be backlit, **characterized in that** it comprises said at least one printed circuit (4) according to one or more of the preceding claims.

7. Electric or electronic backlit device according to claim 6, **characterized in that** it comprises:
• at least one backlit capacitive button or at least one backlit plate (6), in turn comprising at least one support (61) with or without a capacitive sensor,
• at least one of said printed circuits (4) with at least one lighting body (3) positioned in such a way as to backlight at least part of said capacitive button or plate (6) through said support (61),
and wherein said support (61), with or without a capacitive sensor, is superimposed on and directly or indirectly adheres to said emissive side (12) of said printed circuit (4).

## Patentansprüche

1. Gedruckte Schaltung (4), hergestellt aus einem flachen Substrat (1) aus starrem oder flexiblem festem Material, wobei das Substrat (1) wenigstens eine erste Seite (11), die für die Anbringung des Netzes aus Verbindungen (43) und für den Zusammenbau der Komponenten geeignet ist, sowie eine oder mehrere Durchgangsbohrungen (2) in dem besagten Substrat (1) aufweist, wobei wenigstens eine der besagten Bohrungen (2) einen ersten Abschnitt (23) umfasst, der dazu geeignet ist, wenigstens einen an der besagten ersten Seite (11) montierten Beleuchtungskörper (3) aufzunehmen und zur entgegengesetzten bzw. Emissionsseite (12) des besagten Substrats (1) gerichtet ist, und wobei wenigstens ein Beleuchtungskörper (3) vom LED-Typ in dem besagten Abschnitt (23) wenigstens einer der besagten Bohrungen (2) aufgenommen ist,
und wobei die besagte wenigstens eine Bohrung (2), die den besagten Beleuchtungskörper (3) aufnimmt, zu der besagten Emissionsseite (12) hin angesenkt bzw. in jedem Fall derart geformt ist, dass die Öffnung (22) der besagten Bohrung (2) in der besagten Emissionsseite (12) breiter ist als der besagte erste Abschnitt (23), der den besagten Beleuchtungskörper (3) aufnimmt, und wobei jede der besagten Bohrungen (2), die einen Beleuchtungskörper (3) aufnimmt, Folgendes umfasst:
• den besagten ersten Abschnitt (23), der auf der besagten ersten Seite (11) gewonnen ist und Form und Höhe aufweist, wobei der besagte erste Abschnitt im Wesentlichen die Gesamtheit des Beleuchtungskörpers (3) aufnimmt;
• wenigstens einen zweiten Abschnitt (24), der auf der besagten Emissionsseite (12) gewonnen ist und mit dem besagten ersten Abschnitt (23) kommuniziert, wobei der besagte zweite Abschnitt (24) in der Draufsicht breiter ist als der besagte erste Abschnitt (23),
und wobei der besagte zweite Abschnitt (24) als Diffusor für das vom in der Bohrung (2) selbst aufgenommenen Beleuchtungskörper (3) abgegebene Licht dient.

2. Gedruckte Schaltung (4) nach Patentanspruch 1, **dadurch gekennzeichnet, dass** der besagte zweite Abschnitt (24) von kreisförmiger, polygonaler oder jeglicher sonstigen Form und im Wesentlichen auf den besagten ersten Abschnitt (23) zentriert ist.

3. Gedruckte Schaltung (4) nach vorstehenden Patentansprüchen, **dadurch gekennzeichnet, dass** wenigstens die innere Wand (241) des besagten zweiten Abschnitts (24) der besagten Bohrung (2) lackiert ist oder aus einem reflektierenden Material besteht oder mit diesem und/oder mit Metall überzogen ist.

4. Gedruckte Schaltung (4) nach vorstehenden Patentansprüchen, **dadurch gekennzeichnet, dass** wenigstens die inneren Wände der besagten Bohrungen (2) und der besagten Emissionsseite (12) des besagten Substrats (1) vollständig oder teilweise lackiert sind oder aus einem reflektierenden Material (13) bestehen oder mit diesem und/oder mit einer Metallschicht überzogen sind.

5. Gedruckte Schaltung (4) nach vorstehenden Patentansprüchen, **dadurch gekennzeichnet, dass** sie außerdem wenigstens ein Lichtdiffusionselement (5) umfasst, das vollständig oder teilweise in der besagten Bohrung (2) aufgenommen ist, in einer Position vor dem besagten Beleuchtungskörper (3) und zu dem Zweck, die Diffusion des durch den Beleuchtungskörper (3) selbst abgegebenen Lichts zu verstärken.

6. Elektrische oder elektronische, hinterleuchtete Vorrichtung, wenigstens eine Halterung mit wenigstens einem zu hinterleuchtenden Bereich umfassend sowie wenigstens eine gedruckte Schaltung (4) mit wenigstens einem Beleuchtungskörper (3), der derart positioniert ist, dass er den besagten, wenigstens einen zu hinterleuchtenden Bereich hinterleuchtet, **dadurch gekennzeichnet, dass** sie wenigstens eine gedruckte Schaltung (4) nach einem oder mehreren der vorstehenden Patentansprüche umfasst.

7. Elektrische oder elektronische, hinterleuchtete Vorrichtung nach Patentanspruch 6, **dadurch gekennzeichnet, dass** sie Folgendes umfasst:
• wenigstens eine hinterleuchtete, kapazitive Taste oder wenigstens eine hinterleuchtete Platte (6), welche ihrerseits jeweils wenigstens eine Halterung (61) mit einem oder ohne einen kapazitiven Sensor umfasst,
• wenigstens eine der besagten gedruckten Schaltungen (4) mit wenigstens einem Beleuchtungskörper (3), der derart positioniert ist, dass er wenigstens einen Teil der besagten kapazitiven Taste oder Platte (6) durch die besagte Halterung (61) hinterleuchtet,
und wobei die besagte Halterung (61) mit einem oder ohne einen kapazitiven Sensor auf der besagten Emissionsseite (12) der besagten gedruckten Schaltung (4) aufliegt und direkt oder indirekt an ihr anliegt.

## Revendications

1. Circuit imprimé (4) comprenant au moins un substrat plat (1) en un matériau solide rigide ou flexible, substrat (1) ayant au moins un premier côté (11), indiqué pour l'application du réseau de connexion (43) et pour le montage des composants, et un ou plusieurs trous passants (2) réalisés sur ledit substrat (1), au moins un desdits trous (2) comprenant une première section (23) apte à loger au moins une partie d'au moins un corps d'éclairage (3) monté sur ledit premier côté (11) et tourné vers le côté opposé ou le côté émetteur (12) dudit substrat (1), et où
au moins un corps d'éclairage (3) du type à LED est logé dans ladite section (23) d'au moins un desdits trous (2),
et où ledit au moins un trou (2) logeant ledit corps d'éclairage (3) est évasé vers ledit côté émetteur (12) ou de toute façon galbé de manière à ce que l'ouverture (22) dudit trou (2) sur ledit côté émetteur (12) a des dimensions plus grandes par rapport à celles de ladite première section (23) logeant ledit corps d'éclairage (3), et où chacun desdits trous (2) logeant un corps d'éclairage (3) comprend :
• ladite première section (23) réalisée sur ledit premier côté (11) et ayant une forme et une hauteur, ladite première section logeant essentiellement le corps d'éclairage entier (3) ;
• au moins une deuxième section (24) réalisée sur ledit côté émetteur (12) et communiquant avec ladite première section (23), où ladite deuxième section (24) présente, en vue en plan, des dimensions plus grandes que celles de ladite première section (23),
et où ladite deuxième section (24) sert en tant que diffuseur de la lumière émise par le corps d'éclairage (3) logé dans le trou (2).

2. Circuit imprimé (4) selon la revendication 1, **caractérisé en ce que** ladite deuxième section (24) présente une forme circulaire, polygonale ou une forme quelconque, essentiellement centrée sur ladite première section (23).

3. Circuit imprimé (4) selon les revendications précédentes, **caractérisé en ce qu'**au moins la paroi intérieure (241) de ladite deuxième section (24) dudit trou (2) est peinte ou réalisée ou de toute façon recouverte d'un matériau réfléchissant et/ou d'un placage métallique.

4. Circuit imprimé (4) selon les revendications précédentes, **caractérisé en ce qu'**au moins les parois intérieures desdits trous (2) et ledit côté émetteur (12) dudit substrat (1) sont entièrement ou partiellement peints ou réalisés ou de toute façon recouverts d'un matériau réfléchissant (13) et/ou d'une couche de placage métallique.

5. Circuit imprimé (4) selon les revendications précédentes, **caractérisé en ce qu'**il comprend également au moins un élément de diffusion de la lumière (5), logé entièrement ou partiellement à l'intérieur dudit trou (2), dans une position avant ledit corps d'éclairage (3) et ayant le but d'augmenter la diffusion de la lumière émise par le même corps d'éclairage (3).

6. Dispositif électrique ou électronique rétroéclairé, comprenant au moins un support avec au moins une partie à rétroéclairer et au moins un circuit imprimé (4) avec au moins un corps d'éclairage (3) positionné de manière à rétroéclairer ladite au moins une partie à rétroéclairer, **caractérisé en ce qu'**il comprend ledit au moins un circuit imprimé (4) selon l'une ou plusieurs des revendications précédentes.

7. Dispositif électrique ou électronique rétroéclairé, selon la revendication 6, **caractérisé en ce qu'**il comprend :
• au moins une touche capacitive rétroéclairée ou au moins une plaque rétroéclairée (6), comprenant à son tour au moins un support (61) avec ou sans capteur capacitif,
• au moins un desdits circuits imprimés (4) avec au moins un corps d'éclairage (3) positionné de manière à rétroéclairer au moins une partie de ladite touche ou plaque capacitive (6) à travers ledit support (61),
et où ledit support (61), avec ou sans capteur capacitif, est superposé et directement ou indirectement adhérant audit côté émetteur (12) dudit circuit imprimé (4).
